# EUROPÄISCHE PATENTANMELDUNG

(11) **EP 0 909 834 A2**
(43) Veröffentlichungstag der Anmeldung: **21.04.1999**
(21) Anmeldenummer: 98116742.2
(22) Anmeldetag: 04.09.1998
(51) Int. Cl.: C23C 14/56, B65H 23/00, B65H 20/00

(54) **Folientransportvorrichtung**

(30) Priorität: 11.09.1997 DE 19739833
(71) Anmelder: Leybold Systems GmbH, D-63450 Hanau am Main (DE)
(72) Erfinder: Winter, Erwin, 63456 Hanau (DE); Schwarz, Wolfgang, Dr., 63589 Linsengericht (DE); Schönherr, Bernhard, 35647 Waldsolms (DE); Wenk, Karl-Heinrich, 61231 Bad Nauheim (DE)

(57) **Zusammenfassung**

Bei einer Vorrichtung zum Beschichten von Folien in einer Vakuumkammer ist zum Transport der Folienbahn in die, durch die und aus der Vakuumkammer heraus mindestens eine Transportrolle (6) vorgesehen, auf welcher die transportierte Folienbahn (4) anliegend, parallel zur Rotationsachse der Transportrolle (4) weitertransportierbar ist. Die Vorschubrichtung (V) der auf der Transportrolle (6) schräg auflaufenden Folienbahn (4) bildet mit der Längsachse der Transportrolle (6) einen Winkel α ≠ 0° bzw. α ≠ 90°. Hierdurch wickelt die Folienbahn (4) auf der Mantelfläche (8) der Transportrolle (6) oder auf einem auf der Transportrolle (6) gleitenden Transportband spiralförmig auf und wird schräg zur ihrer Vorschubrichtung (V) entlang eines Transportweges über eine gewünschte Transportstrecke (L) gleitend transportiert. Die Transportrolle (4) ist in einer Durchgangsöffnung (12a,12b) der Vakuumkammer drehbar angeordnet, wodurch die Folienbahn (4) durch die Durchgangsöffnung (12a,12b) vom unter Atmosphärennormaldruck stehenden Auflenraum in den Unterdruck aufweisenden Beschichtungsraum transportierbar ist und kontinuierlich in die Vakuumkammer hinein- und herausgeführt wird, wobei der Kammerunterdruck konstant bleibt.

## Beschreibung

Die Erfindung betrifft eine Folientransportvorrichtung gemäß dem Oberbegriff des Patentanspruchs 1 und die Verwendung der erfindungsgemäßen Folientransportvorrichtung gemäß Patentanspruch 12.

Vorrichtungen zum Transport von z.B. aus Papier oder Kunststoff bestehenden Folienbahnen über einzelne, z. B. hintereinander angeordnete rotierende Rollenwalzen sind bekannt. Derartige Folientransporteinrichtungen werden z. B. in Rotationsdruckanlagen eingesetzt und dienen der kontinuierlichen Zuführung der von Abwickelrollen abgewickelten Folienbahnen zu dem Druckwerk.

Derartige Folienzuführungen werden in bekannter Weise auch in sogenannten Bandbeschichtungsanlagen, wie z. B. in der EP 406 641 A1 beschrieben, eingesetzt. In diesen Beschichtungsanlagen wird z. B. zur Herstellung von Bandkondensatorfolien eine dünne metallische Schicht, z. B. Aluminium, auf die kontinuierlich über Verdampferschiffchen geführte Folienbahn aufgedampft. Da der Aufdampfprozeß unter Vakuumbedingungen durchgeführt wird, sind die Abwickelrolle, die Folienzuführungen und die Aufwickelrolle während des Beschichtungsprozesses innerhalb der Bandbeschichtungsanlage angeordnet. Die Abwickel- und Aufwickelrolle werden erst nach erfolgter Beschichtung der gesamten Folienbahn aus der Vakuumkammer entnommen bzw. gegen neue Wickelrollen ausgetauscht.

Diese Unterbrechung des Beschichtungsprozesses ist mit Nachteilen behaftet, da zur Entnahme der Wikkelrollen die gesamte Beschichtungsanlage zunächst auf Atmosphärendruck zu belüften ist, die Wickel-rollen auszutauschen sind und anschließend die Beschichtungsanlage wieder zu Evakuieren ist, was zeitaufwendig ist und derartige Beschichtungsverfahren verteuert.

Aufgabe der vorliegenden Erfindung ist es, eine Vorrichtung zum Transport von Folienbahnen so auszubilden, daß die Zuführung und der Weitertransport der Folie von einer Abwickelrolle zu einer Bearbeitungsstation und weiter zu einer Aufwickelrolle in einfacher Weise ermöglicht wird, wobei die Nachteile der chargenweisen Bearbeitung, insbesondere Beschichtung gemäß dem Stand der Technik vermieden werden.

Diese Aufgabe wird erfindungsgemäß dadurch gelöst, daß bei einer Vorrichtung zum Transport von Folien, insbesondere von Folienbahnen, eine feststehende, vorzugsweise einen kreisförmigen Querschnitt aufweisende Transportrolle vorgesehen ist, auf deren Mantelfläche die zu transportierende Folie anliegt und auf dieser oder einem Transport-band anliegend gleitet, wobei die Vorschubrichtung der auf der Mantelfläche anliegenden Folienbahn mit der Achse der Transportrolle einen Winkel α ≠ 0° oder α ≠ 90° bildet. Hierdurch gleitet die Folie auf der Mantelfläche direkt oder auf dem Transportband schraubenförmig und wird auf der Mantelfläche der nicht rotierenden Transportrolle entlang deren Axialrichtung transportiert. Hierbei ist die Vorschubrichtung der Folie durch die Richtung der Achse der Transportrolle festgelegt.

Der Transportweg der Folie ist dabei proportional zur axialen Erstreckung der auf der Transportrolle anliegenden Wicklungsabschnitte. Durch Umkehrung des Bandzuges bzw. des Transportbandzuges ist die Transportrichtung der Folienbahn in einfacher Weise umkehrbar, wie in Patentanspruch 8 angegeben.

Zum Aufbringen der Folienbahn auf ein auf der Transportrolle anliegendes Transportband ist vorgesehen, die Folie mittels Transportelementen, wie Bändern, Ketten, Riemen oder einer bereits aufliegenden Folie, schraubenförmig über die Mantelfläche der Transportrolle zu ziehen. Vorteilhaft sind hierfür aus metallischen Werkstoffen bestehende Transportbänder vorgesehen, da der Reibungskoeffizient zwischen der vorzugsweise ebenfalls aus metallischen Werkstoffen gefertigten Mantelfläche der Transportrolle und einem metallischen Transportband gering ist, wodurch nur geringe Zugkräfte zum axiale Vorschub des Transportbandes erforderlich sind. Prinzipiell sind für die Werkstoffe der Mantelfläche und des Transportbandes auch andere Werkstoffpaarungen geeignet, welche einen niedrigen Reibungskoeffizienten ermöglichen. Das Transportband wird hierzu von einem Ende der Transportwalze zu deren anderem Ende mittels entsprechender Umlenkelemente zurückgeführt und bildet damit einen geschlossenen Ring.

Die auf dem Transportband anliegende Folie wird auf dieser dann durch Haftreibung gehalten.

Zum Aufbringen der Folienbahn auf die Transportrolle direkt wird diese endseitig an der Transportbahn oder den Transportelementen befestigt und über die Transportrolle direkt gezogen, wodurch die Folie spiralförmig auf die Mantelfläche aufgewickelt wird.

Die effektive Länge der Transportstrecke ist im wesentlichen durch die axiale Ausdehnung und die Anzahl der Wicklungen der Folie um die Transportrolle wählbar.

Zum Transport einer Folienbahn von einem Halbraum in den durch eine Wand getrennten anderen Halbraum hat sich als besonders vorteilhaft erwiesen, die Transportrolle in einer Öffnung dieser Wand anzuordnen, wie in Anspruch 4 angegeben. Hierbei ragt die Transportrolle mit der auf dieser aufgewickelten, anliegenden Folienbahn beidseitig durch die Öffnung. Von Vorteil ist, daß hierbei eine Öffnung, vorzugsweise eine kreisförmige Öffnung mit nur geringem Öffnungsquerschnitt und Ausdehnung erforderlich ist. Im Vergleich zu anderen, insbesondere rechteckigen Spaltöffnungen sind derartige Öffnungsquerschnitte formstabil.

Gemäß Anspruch 5 ist vorgesehen, den freien Gesamtquerschnitt zwischen der gleitenden, auf der Mantelfläche anliegenden Folie und dem freien Durchmesser der Öffnung derartig zu bemessen, daß eine Ringspaltdichtung zwischen Öffnungsguerschnitt und Folienbahn ausgebildet wird. Diese Ringspaltdichtung ist vorteilhaft, da hierdurch der Strömungsleitwert durch den freien Gesamtquerschnitt verringert ist, wodurch insbesondere Druckdifferenzen zwischen dem ersten und dem zweiten Halbraum aufrechterhalten werden können, da eine ausreichende Druckausgleichsströmung hierfür durch die Öffnung hindurch verhindert wird. Hierdurch ist es auch erfindungsgemäß möglich, die Folie z.B. von einem Atmosphärendruck aufweisenden Außenraum in eine Unterdruck aufweisende Beschichtungskammer einer Bandbeschichtungsanlage hinein und die beschichtete Folienbahn aus der Beschichtungskammer heraus in den Außenraum, z.B. zwecks Aufwicklung auf eine Aufwickelrolle im Durchlaufbetrieb zu transportieren. Hierdurch ist vorteilhaft eine kontinuierliche Beschichtung langer Folienbahnen möglich, wodurch deren Herstellung kostengünstig ist. Hierzu eignen sich insbesondere z. B. aus Kunststoff und/oder aus Papier hergestellte Folienbahnen, wie in Anspruch 10 beansprucht.

Gemäß Anspruch 7 ist vorgesehen, in der Öffnung mindestens eine Nut auszubilden, die über einen Abpumpkanal durch eine Abpumpeinrichtung, vorzugsweise mittels einer oder mehrerer Vakuumpumpen evakuierbar ist. Die z. B. als Ringnut ausgebildete Nut bildet dann eine Zwischenpumpstufe zwischen dem höheren Druckbereich und dem Unterdruckbereich in der Beschichtungskammer, welche den Übergang von Gasteilchen vom Außenraum in die Beschichtungskammer verhindert. Weitere vorteilhafte und die Erfindung weiterbildende Merkmale sind in den weiteren Unteransprüchen angegeben.

Im folgen werden zwei bevorzugte und in den Zeichnungen dargestellte Ausführungsbeispiele der Erfindung näher erläutert. Es zeigen:
- Figur 1a: eine Querschnittsansicht einer Transportrolle mit aufgewickelter Folienbahn nach einem ersten Ausführungsbeispiel,
- Figur 1b: eine Querschnittsansicht einer Transportrolle mit aufgewickelter Folienbahn in einer Vakuumbeschichtungsanlage nach einem zweiten Ausführungsbeispiel und
- Figur 2: eine Transportrolle für eine Bandbeschichtungsanlage nach einem zweiten Ausführungsbeispiel

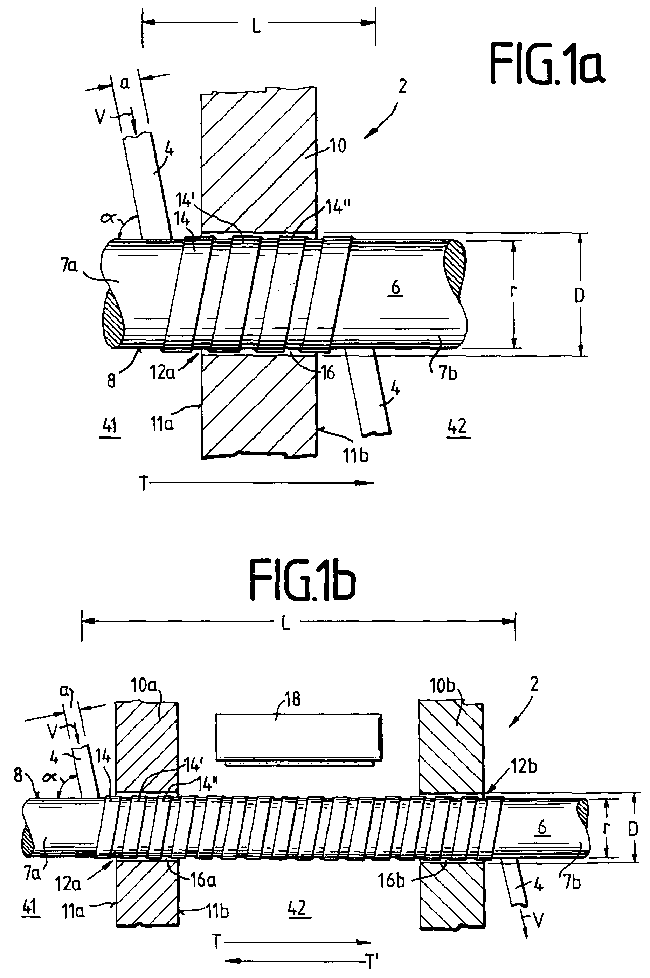

In Fig. 1a ist eine in einer Öffnung 12a einer Kammerwand 10 angeordnete Transportrolle 6 mit aufgewickelter Folienbahn 4 dargestellt. Die Transportrolle 6 ragt beiderseits der Kammerwand 10a in den Halbraum 41 bzw. 42. Auf der Mantelfläche 8 der Transportrolle 6 ist eine Folienbahn 4 mit mehreren Windungen 14,14',14'' aufgewickelt. Die Vorschubrichtung V der Folienbahn 4 bildet mit der Achse A der Transportrolle 6 einen Vorschubwinkel α, wobei gilt α ≠ 0° und α ≠ 90°. Um ein Überlappen der einzelnen Windungen 14,14',14'' auf der Mantelfläche 8 zu verhindern, ist der Vorschubwinkel α in Abhängigkeit der Folienbahnbreite a so zu wählen, daß die Bedingung α ≤ arctan(2πr/a) mit 0° < α < 90° erfüllt ist, wobei der Radius der Transportrolle mit r bezeichnet ist.

Die in Fig. 1b dargestellten Trennwände 10a,10b sind Teil der Kammerwandung einer in Figur 1b nicht vollständig dargestellten Bandbeschichtungsanlage mit einer Verdampferquelle 18 zum Vakuumbedampfen von Folienbahnen 4 mit metallischen Schichten oder Metalloxyden und/oder -nitriten. Zum Beschichten derartiger, eine Foliendicke von typischerweise 0,3 µm bis 2 mm aufweisende Folienbahn 4 wird diese von dem üblicherweise Atmosphärendruck aufweisenden Außenraum 41 auf der Transportrolle 6 durch die Öffnung 12a,12b in die in der Bandbeschichtungsanlage angeordneten Beschichtungskammer 42 transportiert. Die Beschichtungskammer 42 weist typischerweise während des Beschichtungsprozesses einen Druck von 10⁻⁴ mbar bis 10⁻² mbar auf. Zwischen den Windungen der Folienbahn 14,14',14'' und dem freien Durchmesser der Öffnungen 12a,12b ist jeweils ein Ringspalt 16a,16b derartig ausgebildet, daß der Durchfluß von Atmosphärenteilchen aus dem Außenraum 41 in den Unterdruckbereich der Kammer 42 verhindert wird.

Die Länge des gesamten Transportweges L der Folienbahn 4 ist proportional zu der Anzahl der Windungen 14,14',14'' auf der Transportrolle 6.

Die innerhalb der Beschichtungskammer 42 beschichtete Folienbahn 4 wird entweder durch zwei separate Transportrollen in eine Beschichtungskammer hinein- und heraustransportiert oder durch eine einzige Transportrolle 6, wie in Fig. 1b gezeigt, in die Beschichtungskammer hinein und an einer Verdampferquelle 18 vorbeigeführt und anschließend aus der Beschichtungskammer 42 in den Außenraum 41 heraustransportiert und danach üblicherweise auf eine Aufwickelrolle aufgewickelt.

Die Transportrichtung T,T' der Folienbahn 4 ist durch Umkehrung des Bandzuges oder der Transportbandbewegung umkehrbar.

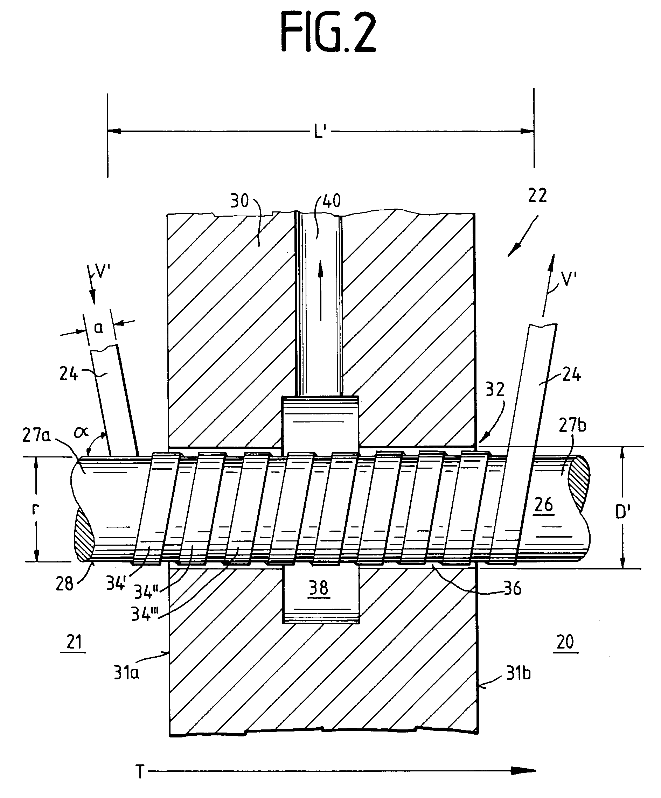

Die in Figur 2 dargestellte Transportrolle 26 ist wie die Transportrolle 6 in Figur 1a bzw. 1b in der Öffnung 32 einer Trennwand 30 angeordnet. Die Trennwand 30 trennt den Innenraum 20 einer nicht weiter dargestellten Beschichtungskammer von dem Außenraum 21. Gemäß der in Figur 2 eingezeichneten Folienvorschubrichtung V' führt die Transportrolle 26 die Folienbahn 24 von dem Atmosphärendruck aufweisenden Außenraum 21 in die Unterdruck aufweisende Beschichtungskammer 20. Zwischen den auf der Mantelfläche 28 anliegenden Windungen 34',34'',34''' der Folienbahn 24 und dem freien Innendurchmesser der Öffnung 32 ist analog zu dem in Figur 1a bzw. 1b dargestellten Ausführungsbeispiel ein Ringspalt 36 ausgebildet, der die Funktion einer Vakuumdichtung zwischen dem Außenraum 21 und dem Inneren 20 der Beschichtungskammer erfüllt. Zur Unterstützung dessen Dichtungseigenschaften weist die Öffnung 32 mindestens eine umlaufende Nut 38 auf, die über einen Abpumpkanal 40 mit einer oder mehreren in der Figur 2 nicht dargestellten Vakuumpumpe auf Unterdruck evakuierbar ist. Die evakuierbare Nut 38 bildet eine zwischen dem Außenraum 21 und dem Inneren 21 der Beschichtungskammer angeordneten Zwischenpumpstufe zur Trennung des Atmosphärenbereich 21 von dem Vakuum-bereich 20. Weitere evakuierbare Zwischenpumpstufen können im Bereich der Öffnung 32 vorgesehen werden. Dabei ist die Anzahl der Zwischenpumpstufen in Abhängigkeit des zwischen dem Außenraum 21 und der Beschichtungskammer 20 vorhandenen Drukkunterschiedes derartig zu wählen, daß ein Druckanstieg in der Beschichtungskammer 20 während des Transports und der Beschichtung der Folienbahn 24 vermieden wird.

Die in der Figur 2 dargestellte Folientransportvorrichtung 22 mit Zwischenpumpstufe ist auch zum Ausschleusen der beschichteten Folienbahn 24 aus dem Inneren 20 der Beschichtungsanlage in entsprechender Anwendung vorgesehen.

Durch die Verwendung der in Figur 1a,1b und Figur 2 dargestellten Folientransportvorrichtungen 2,22 bei Vakuumbandbeschichtungsanlagen können diese als sogenannte Inline-Anlagen in Kombination mit weiteren dem Folienbeschichtungsprozeß vorangeordneten und/oder nachgeordneten und z. B. in InlineBauweise ausgeführten Bearbeitungsvorrichtungen eingesetzt werden, wodurch die gesamte Verarbeitung derartiger Folienbahnen 4,24 in industriellen Anwendungen in kostengünstiger Weise ermöglicht wird.

### Bezugszeichenliste

- 2: Transportvorrichtung
- 4: Folienbahn, Folie
- 6: Transportrolle, Welle
- 7a, 7b: Transportrollenabschnitt
- 8: Mantelfläche
- 10a,10b: Trennwand, Kammerwand
- 11a,11b: Wandseite
- 12a,12b: Öffnung
- 14,14',14'': Windung
- 16a,16b: Ringspalt
- 18: Verdampferquelle
- 20: Beschichtungskammerraum, Halbraum
- 21: Außenraum, Halbraum
- 22: Folientranportvorrichtung
- 24: Folienbahn, Folie
- 26: Transportrolle
- 27a,27b: Transportrollenabschnitt
- 28: Mantelfläche
- 30: Trennwand
- 31a,31b: Wandseite
- 32: Öffnung
- 34',34'',34''': Windung
- 36: Ringspalt
- 38: Nut
- 40: Abpumpkanal
- 41: Außenraum, Halbraum
- 42: Innenraum, Halbraum
- D,D': Öffnungsdurchmesser
- L,L': Transportweg
- S: Strömungsrichtung
- T,T': Axialrichtung, Transportrichtung
- V,V': Vorschubrichtung
- α: Vorschubwinkel
- a,a': Folienbahnbreite
- r: Transportrollenradius

## Patentansprüche

1. Vorrichtung zum Transport von Folien, insbesondere von Folienbahnen, mit einer feststehenden, vorzugsweise einen kreisförmigen Querschnitt aufweisenden Transportrolle, auf deren Mantelfläche die zu transportierende Folie direkt oder auf einem auf der Transportrolle gleitenden Transportband und auf der Transportrolle anliegt, **dadurch gekennzeichnet,** daß die Vorschubrichtung (V,V') der auf der Transportrolle (4,24) auflaufenden Folie (4,24) mit der Achse der Transportrolle (6,64) einen Winkel α ≠ 0° bzw. α ≠ 90° bildet, wodurch die Folie (4,24) auf der Mantelfläche (8,28) der Transportrolle (4,24) oder auf einem auf der Transportrolle (6,26) gleitenden Transportband spiralförmig aufwickelt, und wodurch die Folie (4,24) auf der Transportrolle (6,26) in deren Axialrichtung (T,T') entlang eines Transportweges (L,L') gleitend transportierbar ist.

2. Vorrichtung nach Anspruch 1, **dadurch gekennzeichnet**, daß die Länge des axialen Transportweges (L,L') im wesentlichen der axialen Ausdehnung der auf der Transportrolle (6,26) aufliegenden Wickelabschnitte (14', 14'') entspricht.

3. Vorrichtung nach Anspruch 1 und/oder 2, **dadurch gekennzeichnet,** daß die Wicklung (14',34') der Folie (4,24) auf der Mantelfläche (8,28) über einen Umfangsbereich von mindestens 360° anliegt.

4. Vorrichtung nach Anspruch 1, **dadurch gekennzeichnet,** daß die Transportrolle (6,26) in einer Durchgangsöffnung (12a,12b,32) einer Trennwand (10,30) angeordnet ist und daß die Folienbahn (4,24) auf dem der einen Wandseite (11a,31a) zugeordneten Transportrollenabschnitt (7a,27a) auf der Transportrolle (6,26) aufwickelbar ist und auf der Transportrolle (6,26) spiralförmig gleitend durch die Durchgangsöffnung (12a,12b,32) transportierbar ist, und von dem, der anderen Wandseite (11b,31b) zugeordneten Transportrollenabschnitt (7b,27b) von der Transportrolle (6,26) abwickelbar ist.

5. Vorrichtung nach mindestens einem der Ansprüche 1 bis 4, **dadurch gekennzeichnet,** daß die Wand (10a,10b,30) eine Kammerwand einer verschließbaren Kammer mit einem Innenraum (20,42) ist, in deren Innenraum (20,42) ein von dem Außenraum (21,41) unterschiedlicher atmosphärischer Druck, vorzugsweise Unterdruck einstellbar ist, und daß zwischen dem freien Durchmesser (D,D') der Öffnung (12a,12b,32) und der auf der Transportrolle (6,26) anliegenden Folie (4,24) ein Ringspalt (16,36) ausgebildet ist, dessen Gesamtquerschnitt derartig bemessen ist, daß die Druckdifferenz zwischen dem Innenraum (20,42) und dem Außenraum (21,41) während des axial gerichteten Transports der Folie (4,24) konstant bleibt.

6. Vorrichtung nach mindestens einem der Ansprüche 1 bis 4, **dadurch gekennzeichnet,** daß eine innerhalb der Durchgangsöffnung (12a,12b,36) umlaufende Nut zur Aufnahme eines vorzugsweise elastischen Dichtungselementes vorgesehen ist, welches einerseits dichtend auf der auf der Mantelfläche (8,28) anliegenden Folie (4,24) und andererseits an der Kammerfläche dichtend anliegt, wodurch eine Druckdifferenz zwischen dem Innenraum (20,42) und dem Außenraum (21,41) während des axial gerichteten Transports der Folie (4,24) konstant bleibt.

7. Vorrichtung nach mindestens einem der Ansprüche 1 bis 4, **dadurch gekennzeichnet,** daß die Durchgangsöffnung (36) im Bereich der auf der Transportrolle (26) anliegenden Folienabschnitte (34',34'') mindestens eine, vorzugsweise umlaufende Nut (38) aufweist, in welche ein mit einer Abpumpvorrichtung verbundener evakuierbarer Pumpkanal (40) mündet, durch welchen von dem Außenraum (21) in den Querschnittsbereich des Ringspalts (36) einströmendes Gas abpumpbar ist, wodurch eine den atmosphärischen Druck in dem Innenraum (20) ändernde Gasströmung zwischen dem Innenraum (20) und dem Außenraum (21) weiter reduzierbar ist.

8. Vorrichtung nach mindestens einem der Ansprüche 1 bis 7, **dadurch gekennzeichnet,** daß die Vorschubrichtung (V,V') der Folie (4,24) umkehrbar ist, wodurch die Transportrichtung (T,T') der Folie (4,24) umkehrbar ist und wodurch insbesondere die Folie (4,24) aus dem Innenraum (20,42) in den Außenraum (21,41) transportierbar ist.

9. Vorrichtung nach mindestens einem der Ansprüche 1 bis 8, **dadurch gekennzeichnet,** daß die Folie (4,24) eine Dicke von maximal bis zu 2 mm, vorzugsweise eine Dicke von 0,0005 - 0,003 mm aufweist.

10. Vorrichtung nach mindestens einem der Ansprüche 1 bis 9, **dadurch gekennzeichnet,** daß die Folie (4,24) aus Kunststoff und/oder aus Papier hergestellt ist.

11. Vorrichtung nach Anspruch 1, **dadurch gekennzeichnet,** daß die Transportrolle (6,26) einstückig ausgebildet ist oder aus mehreren, vorzugsweise in Axialrichtung (T,T') aneinandergefügten Teilrollen besteht welche vorzugsweise miteinander koppelbar sind.

12. Verwendung einer Vorrichtung nach mindestens einem der Ansprüche 1 bis 11 für eine Bandbeschichtungsanlage zum kontinuierlichen Transport einer zu beschichtenden Folie (4,24) von einem Atmosphärendruck aufweisenden Außenraum (21,41) in einen evakuierbaren, Unterdruck aufweisenden Beschichtungskammerraum (20,42) einer Bandbeschichtungsanlage und/oder zum Transport einer in einer evakuierbaren Unterdruck aufweisenden Beschichtungskammerraum (20,42) einer Bandbeschichtungsanlage beschichteten Folie in den Atmosphärendruck aufweisenden Außenraum (21,41), wobei die Folie (4,24) in dem Beschichtungskammerraum (20,42) im kontinuierlichen Durchlaufbetrieb beschichtet wird.

13. Verwendung einer Vorrichtung nach Anspruch 12, wobei die Bandbeschichtungsanlage eine Aufdampfeinrichtung oder eine PVD- oder eine CVD-Einrichtung umfaßt, mittels welcher auf die Folie (4,24) aufzudampfende Substanzen, vorzugsweise metallische und/oder metalloxydische und/oder metallnitridische Substanzen, abscheidbar sind.

14. Vorrichtung nach Anspruch 1, **dadurch gekennzeichnet,** daß der Vorschubwinkel α einen Wert 0° < α < 90° aufweist.

15. Vorrichtung nach Anspruch 1, **dadurch gekennzeichnet,** daß der Vorschubwinkel α die Bedingung α ≤ arctan(2πr/a) erfüllt, wobei r der Radius der Transportrolle (6,26) und a die Breite der Folienbahn (4,24) ist.
